# EUROPÄISCHE PATENTSCHRIFT

(11) **EP 1 040 573 B1**
(45) Veröffentlichungstag und Bekanntmachung des Hinweises auf die Patenterteilung: **26.03.2003**
(21) Anmeldenummer: 98960850.0
(22) Anmeldetag: 16.12.1998
(51) Int. Cl.: H03H 7/46, H04B 3/50, H04L 5/06

(54) **FILTERANORDNUNG**
FILTER ARRANGEMENT
ENSEMBLE FILTRE

(30) Priorität: 23.12.1997 AT 218297
(43) Veröffentlichungstag der Anmeldung: 04.10.2000
(73) Patentinhaber: ERICSSON AUSTRIA AKTIENGESELLSCHAFT, 1120 Wien (AT)
(72) Erfinder: PFEIFFER, Johann, A-1100 Wien (AT); LISTOPAD, Manfred, A-1030 Wien (AT)
(74) Vertreter: Gibler, Ferdinand, Dipl.Ing. Dr. techn.
(86) Internationale Anmeldenummer: AT9800307
(87) Internationale Veröffentlichungsnummer: WO99034507

(56) Entgegenhaltungen:
- EP-A- 0 677 938
- WO-A-97/11534
- WO-A-97/48206

## Beschreibung

Die Erfindung betrifft eine Filteranordnung zur Trennung von gleichzeitig auf einer Zweidrahtleitung eines Nachrichtenübertragungssystems übertragenen, analogen, oder digitalen Basisbandsignalen, z.B. POTS- oder ISDN-Signalen, und digitalen Breitbandsignalen, mit einem bidirektionalen Tießpaßfilter, das in seinem Durchlaßbereich für die Basisbandsignale durchlässig ist, und einem bidirektionalen Hochpaßfilter, das in seinem Durchlaßbereich für die Breifbandsignale durchlässig ist.

Breitbandverfahren wie ADSL, VDSL und xDSL o.ä. nützen das Frequenzband oberhalb des Basisbandes, das z.B. von POTS (Plain Old Telephone)- oder ISDN-Signalen belegt ist. Diese unterschiedlichen Übertragungsdienste verwenden in einem Telephonsystem dieselbe Teilnehmerleitung als Übertragungsmedium.

So ermöglicht das immer mehr Bedeutung erlangende Breitbandübertragungsverfahren ADSL (Asymmetric Digital Subscriber Line) die digitale Informationsübertragung großer Datenmengen über eine Zweidraht-Teilnehmeranschlußleitung in einer Richtung von einer zentralen Stelle, z.B. einem Wählamt, zum Teilnehmer und die Übertragung von Steuerfunktionen in beiden Richtungen. Derzeit werden bei ADSL-Nachrichtenübertragungssystemen vielfach QAM-Verfahren angewandt, z.B. DMT (Diskrete Mehrfach-Tonmodulation) oder CAP (CArrierless Phasemodulation), wobei die gebildeten Signale den analogen oder digitalen Telephonsignalen, z.B. POTS oder ISDN, frequenzmäßig überlagert werden. Sowohl auf der Amtsseite als auch teilnehmerseitig wird das auf der Teilnehmerleitung zu übertragende bzw. übertragene Signal über eigene Filteranordnungen (ADSL-Splitter-Filter) zum Empfangen in die zwei Komponenten Basisbandsignale und Breitnandsignale getrennt und zum Senden überlagert.

Zu diesem Zweck sind etwa ADSL-Filter aus einem bidirektionalen Tiefpaß- und einem bidirektionalen Hochpaßfilter zusammengesetzt, wobei das POTS- bzw. das ISDN-Signal über das Tiefpaßfilter und das ADSL- bzw. DMT-Signal über das Hochpaßfilter aus dem Leitungssignal getrennt werden.

Eine Filteranordnung dieser Art findet in der WO-A1-97/11534 zur gleichzeitigen Übertragung von Breitbandsignalen und digitalen ISDN-Basisbandsignalen oder analogen Signalen über eine Zweidrahtleitung Verwendung. Eine bidirektionale Breitbandübertragungseinrichtung und eine ISDN-Vermittlungseinheit einer zentralen Stelle sind dabei über eine ADSL-Filteranordnung mit einem Ende der Zweidrahtleitung verbunden, über die Daten gesendet bzw. empfangen werden können. Das andere Ende der Zweidrahtleitung ist über eine weitere ADSL-Filteranordnung an eine teilnehmerseitige, bidirektionale Breitbandübertragungseinrichtung und einen ISDN-Netzwerkanschluß angeschlossen. Die Durchlaßgrenze des Tiefpaßfilters der ADSL-Filteranordnung ist jeweils so gewählt, daß dessen Bandbreite für die Übertragung der Basisbandsignale ausreichend ist.

Abhängig von den national unterschiedlichen Eingangsimpedanzen wird das Tiefpaßfilter als passives oder analoges aktives Filter jeweils für einen Teilnehmer bereitgestellt.

Weiters geht aus der EP-A1-677 938 eine aus einem Tief- und einem Hochpaß-Filter zusammengesetzte Filteranordnung hervor, über welche Basisband-POTS- und Breitband-ADSL-Signale an eine gemeinsame Zweidrahtleitung ankoppelbar sind. Ein Teil des ADSL-Signals kann dabei durch das POTS-Tiefpaß-Filter verlorengehen, wenn das POTS-Signal durch die Zweidrahtleitung nicht ausreichend gedämpft wird. Das tritt beispielsweise dann ein, wenn die Zweidrahtleitung zu kurze Länge aufweist. Der Grund für diesen Verlust des ADSL-Signals liegt darin, daß sich die Filter-Eigenschaften des Tiefpaß-Filters durch ein zu hohes POTS-Signal verändern körnnen, weil z.B. Filter-Induktivitäten in die magnetische Sättigung gehen. Das Tiefpaß-Filter selbst weist Serien-Drosseln auf, die für Gleichstrom durchlässig sind. Ein zu hohes Gleichsignal verursacht eine Sättigung dieser Drosseln und verkleinert dadurch deren Induktivität, wodurch ein Teil des ADSL-Signals über den Tiefpaß-Filter geleitet wird und verlorengeht. Um eine Sättigung der Tiefpaß-Drosseln zu vermeiden, ist zwischen der POTS-Einheit und dem Tiefpaß-Filter eine veränderbare Impedanz geschaltet, die durch ein Steuersignal gesteuert wird, welches in Abhängigkeit von der Dämpfung auf der Zweidrahtleitung den Impedanzwert der veränderbaren Impedanz so einstellt, daß ein zu hohes POTS-Empfangssignal gedämpft wird, während POTS-Signale mit normalem Pegel ungedämpft weitergeleitet werden.

Ein Nachteil der bekannten Breifbandfilteranordnungen liegt im sehr hohen Platzaufwand, der für den Aufbau eines analogen Filters erforderlich ist. Weiters müssen die nationalen Telephoneingangsimpedanzen immer berücksichtigt werden, woraus sich für jedes Land unterschiedliche Ausführungsformen der Filteranordnungen ergeben.

Aufgabe der Erfindung ist es daher, eine Filteranordnung der eingangs genannten Art anzugeben, welche nur geringen Platzbedarf erfordert und die auf einfache Weise und unter geringem Aufwand an die jeweiligen Erfordernisse hinsichtlich der teilnehmerspezifischen Endgerät-Impedanzen anpaßbar ist.

Erfindungsgemäß wird dies dadurch erreicht, daß das Tiefpaßfilter aus zumindest einem ersten, gleichstromdurchlässigen Filter mit einem ersten Durchlaßbereich und zumindest einem zweiten Filter mit einem zweiten Durchlaßbereich zusammengesetzt ist, sodaß der erste und der zweite Durchlaßbereich zusammen im wesentlichen den Durchlaßbereich des Tiefpaßfilters ausbilden, und daß die Eingänge des ersten und des zweiten Filters parallelgeschaltet sind.

Der Grundgedanke der Erfindung besteht darin, die Tiefpaßfilterung der Basisbandsignale in zumindest zwei Filterbereiche zu unterteilen, um so eine bessere Anpassung der Filterung an die vorliegenden Anforderungen zu ermöglichen, wodurch für jeden Filterbereich eine besonders günstige Filtermöglichkeit vorgesehen werden kann. Dabei können die beiden Filterbereiche so gewählt werden, daß bestehende Frequenzlücken der Übertragungssignale zwischen diesen zu liegen kommen und somit ein Überschneidungsbereich der Filterbereiche nicht erforderlich ist. Das erste, gleichstromdurchlässige Tiefpaß-Filter kann in diskreter Bauweise relativ einfach ausgeführt werden, es entfällt damit aber die Gleichstromdurchlässigkeit für das zweite Filter, welches somit speziell für relativ höhere Frequenzbereiche dimensionierbar ist.

Gemäß einer weiteren Ausbildung der Erfindung können die Ausgänge des ersten und des zweiten Filters parallelgeschaltet sein.

In weiterer Ausbildung der Erfindung kann vorgesehen sein, daß das erste Filter aus einem Tiefbereichs-Tiefpaßfilter und das zweite Filter aus einem Hochbereichs-Bandpaßfilter gebildet ist, wobei der Durchlaßbereich des Tiefbereichs-Tiefpaßfilters von Gleichstromdurchlässigkeit bzw. 0Hz bis zu einer ersten oberen Grenzfrequenz und der Durchlaßbereich des Hochbereichs-Bandpaßfilters von einer zweiten unteren Grenzfrequenz bis zu einer zweiten oberen Grenzfrequenz reicht, und wobei die erste obere Grenzfrequenz vorzugsweise kleiner als die zweite untere Grenzfrequenz ist.

Damit wird der Basisbandfrequenzbereich von zwei Filtern in einen unteren und einen oberen Bereich unterteilt, wobei der untere Bereich für Gleichstrom durchlässig ist, was Voraussetzung für die Aufrechterhaltung der Speisung der einzelnen Teilnehmer ist. Weiters deckt der untere Frequenzbereich auch niederfrequente Wechselspannungen, wie z.B. die Rufspannung, ab. Zwischen der ersten oberen und der zweiten unteren Grenzfrequenz kann auch eine Frequenzlücke ausgebildet sein, die nicht weiter störend wirkt, da in herkömmlichen Telephonnetzen zwischen den Frequenzbereichen für die Signalisierung bzw. Speisung und den unteren Sprachfrequenzen keine zu übertragenden Signalfrequenzen auftreten.

Das Tiefbereichs-Tiefpaßfilter kann auf einfache Weise als passiver Tiefpaß ausgeführt sein, der beispielsweise Induktivitäten und Kapazitäten enthält. Die Anforderungen für den unteren Frequenzbereich, welcher Gleichstrom und niedrige Frequenzen beinhaltet, sind aber gegenüber dem oberen Frequenzbereich der Tiefpaßfilterung entsprechend gering, sodaß eine weitere Vereinfachung oder Platzersparnis kaum möglich ist.

Für den oberen Frequenzbereich der Tiefpaßfilterung wird jedoch eine bedeutende Reduktion der Abmessungen des dafür vorgesehenen Filters erreicht, in dem gemäß einer Variante der Erfindung das Hochbereichs-Bandpaßfilter aus zumindest einer einen digitalen Signalprozessor umfassenden Schaltungsanordnung gebildet ist. In weiterer Ausbildung der Erfindung ist es aber auch möglich, das Hochbereichs-Bandpaßfilter aus zumindest einer einen digitalen Filter umfassenden Schaltungsanordnung zu bilden.

Durch die dadurch ermöglichte digitale Filterung fallen die relativ sperrigen Eisenkerne der herkömmlichen Tiefpaßfilter weg, sodaß der für letztere erforderliche Platz erheblich verkleinert werden kann. Ein weiterer Vorteil liegt in der hohen Anpassungsfähigkeit des erfindungsgemäßen DSP-Filters. Die Telephonnetz-Betreiber geben oft unterschiedliche, reelle oder komplexe Leitungsimpedanzen für ihre POTS-Teilnehmer vor, wobei komplexe Impedanzen ein aktive Breitband-Filterung erfordern. Wird die POTS-Konfiguration hingegen auf eine rein reelle Impedanz festgelegt, genügt eine passive Breitband-Filteranordnung. Da die Filtercharakteristik durch geeignete Programmierung des digitalen Signalprozessors einstellbar ist, kann aber sowohl eine reelle (600 Ohm) als auch eine komplexe Eingangsimpedanz (z.B. Zₙ) angepaßt werden.

Besonders bevorzugt ist dabei eine Wahl der Grenzfrequenzen, die gemäß einem Ausführungsbeispiel der Erfindung dadurch bestimmt sein können, daß die erste obere Grenzfrequenz im Bereich zwischen 25Hz und 70 Hz, vorzugsweise 50 Hz, und die zweite untere Grenzfrequenz im Bereich zwischen 250 Hz und 350 Hz, vorzugsweise 300 Hz, beträgt.

Damit wird die Durchlässigkeit des Tiefpaßfilters sowohl für Signalisierung und Speisung als auch für die tiefsten Sprachsignalfrequenzen ermöglicht.

Dabei kann gemäß einem weiteren Ausführungsbeispiel der Erfindung vorgesehen sein, daß die zweite obere Grenzfrequenz im Bereich zwischen 3300 Hz und 3500 Hz, vorzugsweise 3400 Hz, beträgt.

Dadurch ist die erfindungsgemäße Filteranordnung im POTS-Kanal auch für die höchsten definierten Sprachsignalfrequenzen durchlässig.

Wenn auch die Übertragung von Gebührenimpulsen über das Hochbereichs-Bandpaßfilter ermöglicht werden soll, kann in weiterer Ausbildung der Erfindung vorgesehen sein, daß die zweite obere Grenzfrequenz im Bereich zwischen 11 kHz und 13 kHz, vorzugsweise 12 kHz, oder im Bereich zwischen 15 kHz und 17 kHz, vorzugsweise 16 kHz, beträgt.

Gemäß einer anderen Variante der Erfindung kann die gleichzeitige Übertragung von digitalen ISDN-Signalen und digitalen Breitbandsignalen dadurch vorteilhaft verwirklicht werden, daß die zweite obere Grenzfrequenz im Bereich größer 70 kHz, vorzugsweise 80 kHz, beträgt.

Dadurch werden auch die ISDN-Signale durch das Hochbereichs-Bandpaßfilter hindurchgelassen und können so an das dafür vorgesehene Teilnehmerendgerät bzw. an die entsprechende ISDN-Einheit gelangen. Damit ist neben einer Übertragung von ADSL- und

POTS-Signalen auch die von ISDN-Signalen oder zu diesen verwandten Signalen, wie z.B. PCM-2, PCM-4 o.ä. möglich.

Weiters betrifft die Erfindung ein System zur gleichzeitigen Übertragung von analogen oder digitalen Basisbandsignalen, z.B. POTS- oder ISDN-Signalen, und digitalen Breitbandsignalen für mehrere Teilnehmer, mit je einer erfindungsgemäßen Filteranordnung für jede Teilnehmerleitung, welche in einer zentralen Stelle eines Nachrichtenübertragungssystems, z.B. in einem Wählamt, angeordnet sind.

Bisher mußten in Wählämtern zur Abtrennung der Breitbandsignale alle Basisbandsignale über separate Breitbandfilteranordnungen geführt werden, wobei für jede Teilnehmerleitung jeweils ein diskretes Hoch- und Tiefpaßfilter vorgesehen war. Diese Filter können abhängig von den jeweiligen nationalen und regionalen Bestimmungen entweder passiv oder aktiv ausgeführt sein. Der Platzbedarf aufgrund der für den Aufbau der Filter erforderlichen Eisenkerne ist relativ hoch, er beträgt für jedes Filter in der Größenordnung von ungefähr 90 cm², sodaß bei mehreren Teilnehmern in vielen bestehenden Wählämtern rasch eine Obergrenze erreicht ist, die aus Platzmangel nicht überschritten werden kann. Des weiteren ergibt sich für das zusätzliche Vorsehen einer Breitbandfilteranordnung für jeden Teilnehmeranschluß ein Grundaufwand an Wartungs- und Ausfallszeiten.

Aufgabe der Erfindung ist es daher, ein System anzugeben, mit dem der für eine Breitbandübertragung erforderliche Platzbedarf gegenüber bekannten System gesenkt werden kann.

Weitere Aufgabe der Erfindung ist es, ein System mit geringem Wartungsbedarf zu schaffen. Erfindungsgemäß wird dies dadurch erreicht, daß die den Teilnehmern zugehörigen Hochbereichs-Bandpaßfilter jeweils als zumindest einen digitalen Signalprozessor umfassende Schaltungsanordnungen ausgebildet sind, und daß die digitalen Signalprozessoren dieser Schaltungsanordnungen in einer einzigen digitalen Signalprozessor-Einheit zusammengefaßt sind.

Durch den Einsatz eines entsprechend leistungsfähigen Signalprozessors kann somit eine Parallelverarbeitung mehrerer Basisbandkanäle, z.B. POTS- und/oder ISDN-Kanäle, vorgenommen werden. Die Filtercharakteristik kann für jeden Kanal entsprechend angepaßt werden. Durch die Zusammenfassung mehrerer Hochbereichs-Bandpaßfilter in einer DSP-Einheit läßt sich neben dem Platzeinsparungseffekt generell ein niedrigerer Wartungs- und Geräteaufwand erzielen.

Nachstehend wird die Erfindung anhand der in den Zeichnungen dargestellten Ausführungsbeispiele eingehend erläutert. Es zeigt dabei
Fig.1 ein Blockschaltbild einer Filteranordnung gemäß dem Stand der Technik;
Fig.2 ein Blockschaltbild einer Ausführungsform der erfindungsgemäßen Filteranordnung;
Fig.3 ein Diagramm der Filtercharakteristik einer Ausführungsform der erfindungsgemäßen Filteranordnung;
Fig.4, 5, 6 und 7 jeweils ein Blockschaltbild einer weiteren Ausführungsform der erfindungsgemäßen Filteranordnung.

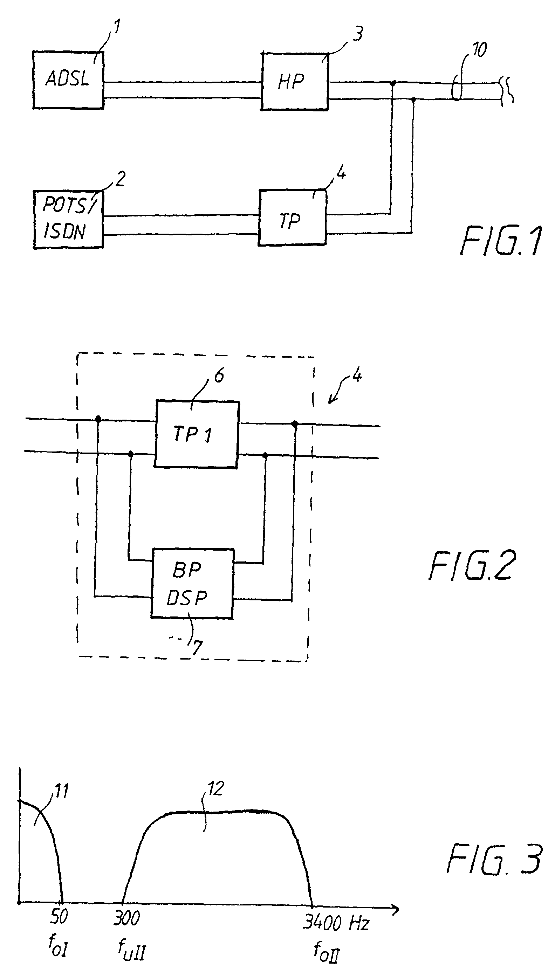

In Fig.1 ist eine Filteranordnung zur Trennung von gleichzeitig auf einer Zweidrahtleitung 10 eines Nachrichtenübertragungssystems übertragenen, analogen oder digitalen Basisbandsignalen gemäß dem Stand der Technik dargestellt.

Auf der Zweidraht-Teilnehmerleitung 10, die z.B. von einem Wählamt zu einem Teilnehmer führt, können dabei analoge oder digitale Basisbandsignale, z.B. POTS- oder ISDN-Signale und diesen frequenzmäßig überlagerte, digitale Breitbandsignale, z.B. ADSL-Signale gesendet und empfangen werden. Die hier beispielhaft beschriebene Art der Basisband- und Breitbandsignale stellt keine Einschränkung der Erfindung dar.

Zur Trennung der auf der Teilnehmerleitung 10 überlagerten Breitband- und Basisbandsignale ist ein bidirektionales Tießpaßfilter 4 und ein bidirektionales Hochpaßfilter 3 vorgesehen, die die Basisbandsignale z.B. an eine POTS- oder ISDN-Einheit 2 und die Breitbandsignale, z.B. ADSL-Signale an eine Breitband-Einheit 1 weiterleiten bzw. diese Signale in der anderen Richtung auf der Teilnehmerleitung 10 vereinen, über die sie an einen Teilnehmer gesendet werden.

Der Nachteil bestehender Filteranordnungen dieser Art besteht darin, daß sich für das Tiefpaßfilter 4 ein relativ hoher Platzbedarf ergibt, da für dessen Realisierung relativ großvolumige Eisenkerne benötigt werden.

Im Ausführungsbeispiel nach Fig.2 wird dem erfindungsgemäß abgeholfen, indem das Tiefpaßfilter 4 aus zumindest einem ersten, gleichstromdurchlässigen Filter 6 mit einem ersten Durchlaßbereich 11 und zumindest einem zweiten Filter 7 mit einem zweiten Durchlaßbereich 12 durch Parallelschaltung der Ein- und Ausgänge der beiden Filter 6, 7 zusammengesetzt ist, welche Durchlaßbereiche beispielhaft in Fig.3 dargestellt sind.

Das erste Filter ist gemäß Fig.2 aus einem Tiefbereichs-Tiefpaßfilter 6 und das zweite Filter aus einem Hochbereichs-Bandpaßfilter 7 gebildet, wobei der Durchlaßbereich des Tiefbereichs-Tiefpaßfilters 6 von Gleichstromdurchlässigkeit bzw. 0 Hz bis zu einer ersten oberen Grenzfrequenz f_{oI} reicht.

In diesem Frequenzbereich können alle Signalisierungs- und Speisungsspannungen übertragen werden, wobei die Durchlässigkeit für Gleichstrom bei 0 Hz funtkionswesentlich ist, da sonst die Speisung des Teilnehmers nicht durchführbar ist.

Die erste obere Grenzfrequenz f_{oI} kann im Bereich zwischen 25Hz und 70 Hz gewählt sein, vorzugsweise liegt sie aber bei 50 Hz, da dies die obere Grenze für die üblichen Rufwechselspannungen darstellt.

Der Durchlaßbereich des Hochbereichs-Bandpaßfilters 7 reicht von einer zweiten unteren Grenzfrequenz f_{uII} bis zu einer zweiten oberen Grenzfrequenz f_{oII}.

Die erste obere Grenzfrequenz f_{oI} des Tiefbereichsfilters 6 ist im Beispiel gemäß Fig.3 kleiner als die zweite untere Grenzfrequenz f_{uII} gewählt, da in dem dazwischenliegenden Bereich weder Basisbandfrequenzen noch der Aufrechterhaltung des Betriebs dienende Frequenzen auftreten.

Das Hochbereichs-Bandpaßfilter 7 ist aus einer zumindest einen digitalen Signalprozessor (DSP) umfassenden Schaltungsanordnung ausgebildet, mit der durch entsprechende Programmierung eine Filtercharakteristik, wie sie dem Bereich 12 in Fig.3 entspricht, erzeugt werden kann. Diese Schaltungsanordnungen beinhalten neben den Signalprozessoren noch andere Einheiten, wie z.B. Analog/Digital-Wandler, die zur Nachbildung eines Filters unerläßlich sind. Anstelle der DSP sind aber auch digitale Filter anwendbar. Diese können im Vergleich zu DSP kostengünstig als ASIC-Schaltkreise verwirklicht werden, sobald eine entsprechende Produktions-Stückzahl überschritten wird.

Damit sind die platzaufwendigen Eisenkerne der herkömmlichen Tiefpaßfilter völlig gleichwertig ersetzbar, was eine erhebliche Platzbedarfserniedrigung zur Folge hat.

Die zweite untere Grenzfrequenz f_{uII} des DSP 7 liegt dabei vorzugsweise im Bereich zwischen 250 Hz und 350 Hz, vorzugsweise 300 Hz, und die zweite obere Grenzfrequenz f_{oII} im Bereich zwischen 3300 Hz und 3500 Hz, vorzugsweise 3400 Hz, sodaß der übliche Sprachsignalbereich damit innerhalb des Durchlaßbereiches zu liegen kommt.

Sollen zusätzlich auch Gebührenimpulse über das Hochbereichs-Bandpaßfilter gelangen können , kann die zweite obere Grenzfrequenz f_{oII} im Bereich zwischen 11 kHz und 13 kHz, vorzugsweise 12 kHz, oder im Bereich zwischen 15 kHz und 17 kHz, vorzugsweise 16 kHz, gewählt werden.

Für ISDN-Anwendungen wird dementsprechend die zweite obere Grenzfrequenz im Bereich größer 70 kHz, vorzugsweise 80 kHz, gewählt, sodaß auch die ISDN-Signale bis zur entsprechenden ISDN-Einheit gelangen können bzw. von dieser gesendet werden können.

In Fig.2 ist eine Parallelschaltung der jeweiligen Ein- und Ausgänge des Tiefbereichs-Tiefpaßfilters 6 und des Hochbereichs-Bandpaßfilter 7 gezeigt.

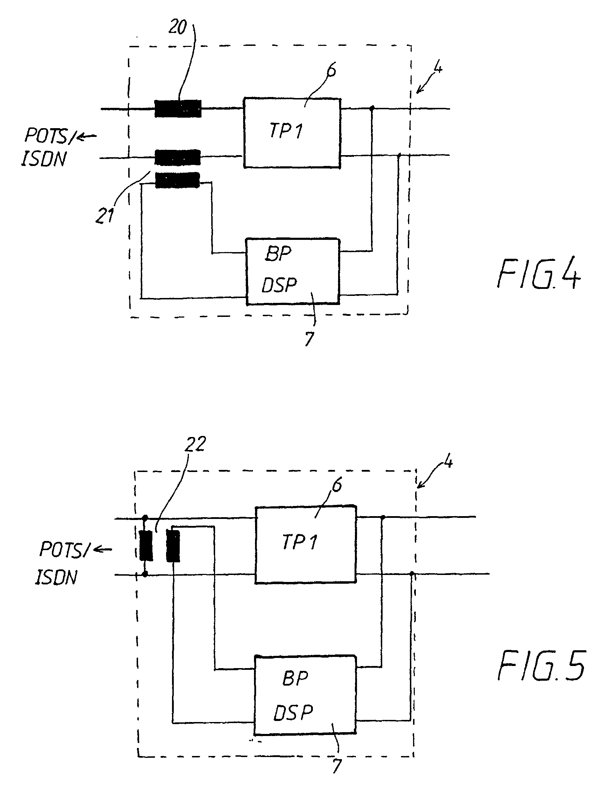

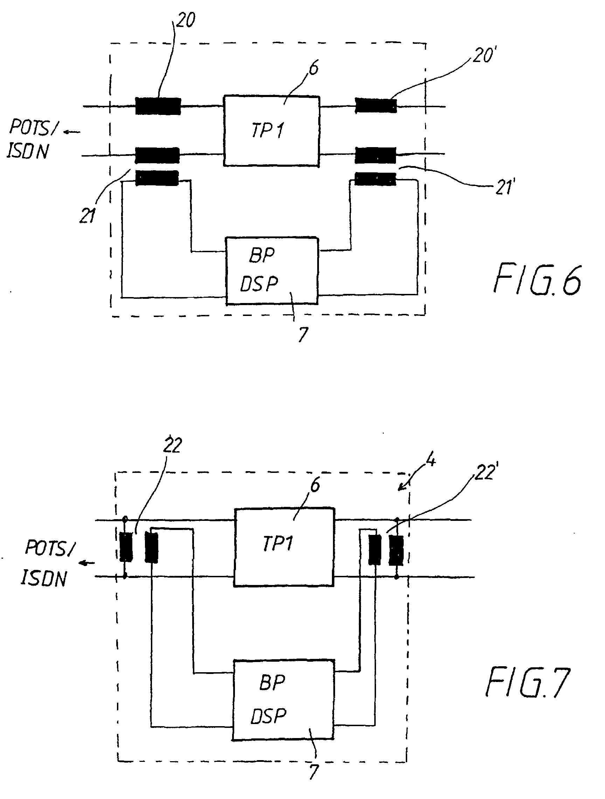

Um aber alle Erfordernisse für eine richtige Anpassung an das jeweilige Telephonsystem zu erfüllen, besteht eine wichtige Maßnahme darin, eine Anpassung der Filteranordnung an die Eingangsimpedanz des Teilnehmers bzw. der entsprechenden POTS- bzw. ISDN- Einheit 2 vorzunehmen. Dazu sind in den Ausführungsbeispielen gemäß Fig.4, 5, 6 und 7 entsprechende Schaltungsvarianten gezeigt, mit denen die richtige Anpassung durch entsprechende Dimensionierung der den Ein- bzw. Ausgängen vorgeschalteten Induktivitäten 20, 20' und Wandlern bzw. Signalübertragern 21, 21'und 22, 22' vorgenommen werden kann. Mischformen dieser Varianten sind ebenso durchführbar.

In Wählämtern oder anderen zentralen Stellen eines Nachrichtenübertragungssystems wird für jeden Teilnehmer bzw. jede Teilnehmerleitung je eine Filteranordnung benötigt. Um den Aufwand an einzelnen getrennten Einheiten zu verringern, kann erfindungsgemäß vorgesehen sein, daß die den Teilnehmern zugehörigen Hochbereichs-Bandpaßfilter als zumindest einen digitalen Signalprozessor umfassende Schaltungsanordnungen ausgebildet und die Signalprozessoren in einer einzigen digitalen Signalprozessor-Einheit zusammengefaßt sind. Wird der Signalprozessor entsprechend leistungsfähig dimensioniert, kann eine Parallelverarbeitung mehrerer POTS- bzw. ISDN-Kanäle erfolgen und die Filtercharakteristik entsprechend den jeweiligen Anforderungen, insbesondere an die Eingangsimpedanzen, angepaßt werden.

## Patentansprüche

1. Filteranordnung zur Trennung von gleichzeitig auf einer Zweidrahtleitung eines Nachrichtenübertragungssystems übertragenen, analogen oder digitalen Basisbandsignalen, z.B. POTS- oder ISDN-Signalen, und digitalen Breitbandsignalen, mit einem bidirektionalen Tießpaßfilter, das in seinem Durchlaßbereich für die Basisbandsignale durchlässig ist, und einem bidirektionalen Hochpaßfilter, das in seinem Durchlaßbereich für die Breitbandsignale durchlässig ist, **dadurch gekennzeichnet, daß** das Tiefpaßfilter (4) aus zumindest einem ersten, gleichstromdurchlässigen Filter (6) mit einem ersten Durchlaßbereich und zumindest einem zweiten Filter (7) mit einem zweiten Durchlaßbereich zusammengesetzt ist, sodaß der erste und der zweite Durchlaßbereich zusammen im wesentlichen den Durchlaßbereich des Tiefpaßfilters (4) ausbilden, und daß die Eingänge des ersten und des zweiten Filters (6, 7) parallelgeschaltet sind.

2. Filteranordnung nach Anspruch 1, **dadurch gekennzeichnet, daß** die Ausgänge des erstein und des zweiten Filters (6,7) parallelgeschaltet sind.

3. Filteranordnung nach Anspruch 1 oder 2, **dadurch gekennzeichnet, daß** das erste Filter (4) aus einem Tiefbereichs-Tiefpaßfilter (6) und das zweite Filter aus einem Hochbereichs-Bandpaßfilter (7) gebildet ist, wobei der Durchlaßbereich des Tiefbereichs-Tiefpaßfilters (6) von Gleichstromdurchlässigkeit bzw. 0 Hz bis zu einer orsten oberen Grenzfrequenz und der Durchlaßbereich des Hochbereichs-Bandpaßfilters (7) von einer zweiten unteren Grenzfrequenz bis zu einer zweiten oberen Grenzfrequenz reicht, und wobei die erste obere Grenzfrequenz vorzugsweise kleiner als die zweite untere Grenzfrequenz ist.

4. Filteranordnung nach Anspruch 1, 2 oder 3, **dadurch gekennzeichnet, daß** das Hochbereichs-Bandpaßfilter aus zumindest einer einen digitalen Filter umfassen den Schaltungsanordnung gebildet ist.

5. Filteranordnung nach Anspruch 1, 2 oder 3, **dadurch gekennzeichnet, daß** das Hochbereichs-Bandpaßfilter aus zumindest einer einen digitalen Signalprozessor (7) umfassenden Schaltungsanordnung gebildet ist.

6. Filteranordnung nach einem der Ansprüche 3 bis 5, **dadurch gekennzeichnet, daß** die erste obere Grenzfrequenz im Bereich zwischen 30Hz und 70 Hz, vorzugsweise 50 Hz, und die zweite untere Grenzfrequenz im Bereich zwischen 250 Hz und 350 Hz, vorzugsweise 300 Hz, beträgt

7. Filteranordnung nach einem der Ansprüche 3 bis 6, **dadurch gekennzeichnet, daß** die zweite obere Grenzfrequenz im Bereich zwischen 3300 Hz und 3500 Hz, vorzugsweise 3400 Hz, betragt.

8. Filteranordnung nach einem der Ansprüche 3 bis 6, **dadurch gekennzeichnet, daß** die zweite obere Grenzfrequenz im Bereich zwischen 11 kHz und 13 kHz, vorzugsweise 12 kHz, oder im Bereich zwischen 15 kHz und 17 KHz, vorzugsweise 16 kHz, beträgt.

9. Filteranordnung nach einem der Ansprüche 3 bis 6, **dadurch gekennzeichnet, daß** die zweite obere Grenzfrequenz im Bereich zwischen 70 kHz und 90 kHz, vorzugsweise 80 KHz, beträgt.

10. System zur gleichzeitigen Übertragung von analogen oder digitalen Basisbandsignalen, z.B. POTS- oder ISDN-Signalen, und digitalen Breitbandsignalen für mehrere Teilnehmer, mit je einer Filteranordnung nach einem der Ansprüche 1 bis 9 für jede Teilnehmerleitung, welche in einer zentralen Stelle eines Nachrichtenübertragungssystems, z.B. in einem Wählamt, angeordnet sind, **dadurch gekennzeichnet, daß** die den Teilnehmern zugehörigen Hochbereichs-Bandpaßfilter (7) jeweils als zumindest einen digitalen Signalprozessor umfassende Schaltungsanordnungen ausgebildet sind, und daß die digitalen Signalprozessoren dieser Schaltungsanordnungen in einer einzigen digitalen Signalprozessor-Einheit zusammengefaßt sind.

## Claims

1. A filter arrangement for separating analog or digital baseband signals, e.g. POTS or ISDN signals, and digital broadband signals, which are transmitted simultaneously on a two-wire line of a telecommunications system, comprising a bidirectional low-pass filter which is transmissive in its pass range for the baseband signals and a bidirectional high-pass filter which is transmissive in its pass range for the broadband signals, **characterized in that** the low-pass filter (4) is composed at least of a first d.c. transmissive filter (6) with a first pass range and at least of a second filter (7) with a second pass range, so that the first and second pass range jointly substantially form the pass range of the low-pass filter (4), and that the inputs of the first and second filter (6, 7) are connected in parallel.

2. A filter arrangement as claimed in claim 1, **characterized in that** the outputs of the first and second filter (6, 7) are connected in parallel.

3. A filter arrangement as claimed in claim 1 or 2, **characterized in that** the first filter (4) is formed by a low-band low-pass filter (6) and the second filter by a high-band high-pass filter (7), with the pass range of the low-band low-pass filter (6) ranges from d.c. transmissivity or 0 Hz up to a first upper cut-off frequency and the pass range of the high-band high-pass filter (7) ranges from a second lower cut-off frequency up to a second upper cut-off frequency, and with the first upper cut-off frequency preferably being lower than the second lower cut-off frequency.

4. A filter arrangement as claimed in claim 1, 2 or 3, **characterized in that** the high-band band pass filter is formed by at least one filter arrangement comprising a digital filter.

5. A filter arrangement as claimed in claim 1, 2 or 3, **characterized in that** the high-band band pass filter is formed by at least one circuit arrangement comprising a digital signal processor (7).

6. A filter arrangement as claimed in one of the claims 3 to 5, **characterized in that** the first upper cut-off frequency is in the range of between 30 Hz and 70 Hz, preferably 50 Hz, and the second lower cut-off frequency is in the range of between 250 Hz and 350 Hz, preferably 300 Hz.

7. A filter arrangement as claimed in one of the claims 3 to 6, **characterized in that** the second upper cut-off frequency is in the range of between 3300 Hz and 3500 Hz, preferably 3400 Hz.

8. A filter arrangement as claimed in one of the claims 3 to 6, **characterized in that** the second upper cut-off frequency is in the range of between 11 kHz and 13 kHz, preferably 12 kHz, or in the range of between 15 kHz and 17 kHz, preferably 16 kHz.

9. A filter arrangement as claimed in one of the claims 3 to 6, **characterized in that** the second upper cut-off frequency is in the range of between 70 kHz and 90 kHz, preferably 80 kHz.

10. A system for the simultaneous transmission of analog or digital baseband signals, e.g. POTS or ISDN signals, and digital broadband signals for several subscribers, with a filter arrangement each according to one of the claims 1 to 9 for each subscriber line which are arranged at a central location of a telecommunications system, e.g. an automatic exchange, **characterized in that** the high-band band pass filters (7) associated with the subscribers are each arranged as circuit arrangements comprising at least one digital signal processor and that the digital signal processors of said circuit arrangements are combined into a single digital signal processor unit.

## Revendications

1. Dispositif de filtre pour la séparation de signaux en bande de base analogiques ou numériques, par exemple de signaux téléphoniques ordinaires ou RNIS, et de signaux numériques en bande large, transmis simultanément sur une ligne à deux fils d'un système de transmission de messages, avec un filtre passe-bas bidirectionnel laissant passer les signaux en bande de base dans sa largeur de bande passante et avec un filtre passe-haut bidirectionnel qui laisse passer les signaux à large bande dans sa largeur de bande passante, **caractérisé en ce que** le filtre passe-bas (4) se compose d'au moins un premier filtre (6) laissant passer le courant continu et ayant une première bande passante et d'au moins un deuxième filtre (7) ayant une deuxième bande passante, de sorte que la première bande passante et la deuxième constituent ensemble, pour l'essentiel, la largeur de bande passante du filtre passe-bas (4), et **en ce que** les entrées du premier filtre et du deuxième (6, 7) sont connectées en parallèle.

2. Dispositif de filtre selon la revendication 1, **caractérisé en ce que** les sorties du premier filtre et du deuxième (6, 7) sont connectées en parallèle.

3. Dispositif de filtre selon la revendication 1 ou 2, **caractérisé en ce que** le premier filtre (4) se compose d'un filtre passe-bas à bande basse (6) et le deuxième filtre d'un filtre passe-bande à bande haute (7), la bande passante du filtre passe-bas à bande basse (6) allant du passage de courant continu ou de 0 Hz à une fréquence limite supérieure et la bande passante du filtre passe-bande à bande haute (7) allant d'une deuxième fréquence limite inférieure à une deuxième fréquence limite supérieure, et la première fréquence limite supérieure étant de préférence plus basse que la deuxième fréquence limite inférieure.

4. Dispositif de filtre selon la revendication 1, 2 ou 3, **caractérisé en ce que** le filtre passe-bande à bande haute est formé d'au moins un dispositif de circuit comprenant un filtre numérique.

5. Dispositif de filtre selon la revendication 1, 2 ou 3, **caractérisé en ce que** le filtre passe-bande à bande haute est formé d'au moins un dispositif de circuit comprenant un processeur de signaux numérique (7).

6. Dispositif de filtre selon l'une quelconque des revendications 3 à 5, **caractérisé en ce que** la première fréquence limite supérieure est de l'ordre de 30 Hz à 70 Hz, de préférence 50 Hz, et la deuxième fréquence limite inférieure est de l'ordre de 250 Hz à 350 Hz, de préférence 300 Hz.

7. Dispositif de filtre selon l'une quelconque des revendications 3 à 6, **caractérisé en ce que** la deuxième fréquence limite supérieure est de l'ordre de 3300 Hz à 3500 Hz, de préférence 3400 Hz.

8. Dispositif de filtre selon l'une quelconque des revendications 3 à 6, **caractérisé en ce que** la deuxième fréquence limite supérieure est de l'ordre de 11 kHz à 13 kHz, de préférence 12 kHz, ou de 15 kHz à 17 kHz, de préférence 16 kHz.

9. Dispositif de filtre selon l'une quelconque des revendications 3 à 6, **caractérisé en ce que** la deuxième fréquence limite supérieure est de l'ordre de 70 kHz à 90 kHz, de préférence 80 kHz.

10. Système pour la transmission simultanée de signaux en bande de base analogiques ou numériques, par exemple de signaux téléphoniques ordinaires ou RNIS, et de signaux numériques en bande large pour plusieurs participants, avec des dispositifs de filtre selon l'une quelconque des revendications 1 à 9 pour chaque ligne de participant, qui sont disposés dans une zone centrale d'un système de transmission de messages, par exemple un central téléphonique, **caractérisé en ce que** chacun des filtres passe-bande à bande haute (7) correspondant aux participants est conçu comme un dispositif de circuit comprenant au moins un processeur de signaux numérique, et **en ce que** les processeurs de signaux numériques de ces dispositifs de circuit sont réunis dans une seule et même unité numérique de traitement des signaux.
